Europäisches Patentamt

European Patent Office

Office européen des brevets

(19)

(11) **EP 1 412 307 B1**

(12) **EUROPÄISCHE PATENTSCHRIFT**

(45) Veröffentlichungstag und Bekanntmachung des Hinweises auf die Patenterteilung:
**23.11.2005 Patentblatt 2005/47**

(21) Anmeldenummer: 02774310.3

(22) Anmeldetag: **05.09.2002**

(51) Int Cl.⁷: **C04B 37/02**

(86) Internationale Anmeldenummer:
**PCT/DE2002/003275**

(87) Internationale Veröffentlichungsnummer:
**WO 2003/031372 (17.04.2003 Gazette 2003/16)**

(54) **VERFAHREN ZUM HERSTELLEN VON METALL-KERAMIK-VERBUNDMATERIALIEN, INSBESONDERE METALL-KERAMIK-SUBSTRATEN**

METHOD FOR THE PRODUCTION OF METAL-CERAMIC COMPOSITE MATERIALS, ESPECIALLY METAL-CERAMIC SUBSTRATES

PROCEDE DE PRODUCTION DE MATERIAUX COMPOSITES METAL-CERAMIQUE, NOTAMMENT DE SUBSTRATS METAL-CERAMIQUE

(84) Benannte Vertragsstaaten:
**DE FR GB**

(30) Priorität: **01.10.2001 DE 10148550**

(43) Veröffentlichungstag der Anmeldung:
**28.04.2004 Patentblatt 2004/18**

(73) Patentinhaber: **Schulz-Harder, Jürgen, Dr.-Ing.**
**91207 Lauf (DE)**

(72) Erfinder: **Schulz-Harder, Jürgen, Dr.-Ing.**
**91207 Lauf (DE)**

(74) Vertreter: **Graf, Helmut et al**
**Patentanwalt**
**Postfach 10 08 26**
**93008 Regensburg (DE)**

(56) Entgegenhaltungen:
**DE-A- 3 036 128          DE-U- 20 116 816**
**US-A- 3 766 634          US-A- 4 483 810**

**Beschreibung**

Die Erfindung bezieht sich auf ein Verfahren gemäß Oberbegriff Patentanspruch 1.

Unter dem Begriff "Direct-Bonding" sind Verfahren zum Verbinden eines Metalls mit Keramik, d.h. zum Herstellen von Metall-Keramik-Verbundmaterialien bekannt, und zwar unter Verwendung einer als Eutektikum wirkenden und unter Verwendung eines reaktiven Gases erzeugten Oberflächenschicht des Metalls, beispielsweise Metalloxidschicht, die dann beim Erhitzen der gegeneinander anliegenden, zu verbindenden Komponenten Metall und Keramik (nachstehend auch "Verbindungskomponenten") auf eine Prozeß- oder Bonding-Temperatur (eutektische Temperatur) aufschmilzt und unter Benetzung der Keramik als eine Art Lot beim anschließenden Abkühlen die Verbindung zwischen den Verbindungskomponenten herstellt. Die Bonding-Temperatur liegt dabei unterhalb der Schmelztemperatur des Metalls. Insbesondere auch in Abhängigkeit von dem verwenden Metall liegt diese Bonding-Temperatur im Bereich zwischen etwa 714°C (Kupfer-Phosphor) und 1820°C (Chrom-Sauerstoff)

Bei einem bekannten Direct-Bonding-Verfahren (DE 23 19 854/US 3,766,634) wird das Metall zunächst in einer Sauerstoff enthaltenden Schutzgasatmosphäre bei einer Temperatur unterhalb der Bonding-Temperatur oxidiert wird. Anschließend werden das Metall und die Keramik auf die Bonding-Temperatur erhitzt. Danach erfolgt die Abkühlung auf Raumtemperatur. Für das System Kupfer-Sauerstoff wird bei diesem Verfahren ein Sauerstoffgehalt der reaktiven Atmosphäre von 0,01 - 0,5 Volumenprozent (100 bis 5000 ppm) angegeben.

Bekannt ist auch ein weiterentwickeltes Direct-Bonding-Verfahren (DE 26 338 69/US 3,994,430), bei dem das Metall in einem separaten, dem Bonden vorausgehenden Verfahrensschritt mit dem reaktiven Gas behandelt bzw. oxidiert wird. Nach dem Zusammenführen der zu verbindenden Komponenten Metall und Keramik werden diese in einem Ofen auf die Bonding-Temperatur erhitzt, und zwar in einer Schutzgasatmosphäre mit einem Sauerstoffgehalt in der Größenordnung von 0,01 - 0,5 Volumenprozent (100 - 5000 ppm).

Bekannt ist weiterhin ein Direct-Bonding-Verfahren (DE 30 36 128), bei dem die Verbindung von Kupfer und Keramik in einem Vakuumofen mit einem Sauerstoffgehalt zwischen 0,001 - 0,1 mbar (etwa 1-100 ppm) erfolgt.

Vorgeschlagen wurde auch bereits (DE 32 04 167/US 4,483,810), das Direct-Bonding-Verfahren in einem Durchlauf- oder Tunnelofen unter Schutzgasatmosphäre durchzuführen, wobei der Sauerstoffgehalt durch dosierte Zugabe von Sauerstoff in das Schutzgas auf 20 - 50 ppm eingestellt wird, und zwar bei einer Temperatur zwischen 960°C und 1072°C.

Bei allen vorgenannten, bekannten Verfahren haben liegt der Sauerstoffgehalt der Schutzgasatmosphäre weit über einem Gleichgewichtssauerstoffgehalt oder -anteil des Systems Kupfer-Sauerstoff. Aus der Literatur ist bekannt, daß der Sauerstoffgehalt dieses Systems im Temperaturbereich, bei dem das Direct-Bonding bzw. das DCB-Verfahren durchgeführt wird, in der Größenordnung von 2,6 - 5 ppm liegt.

So ist in "The Metallurgy of Copper" Incra Series, Band II, Seiten 56, 60 für logK der Reaktion $Cu + 1/2\ O_2 = Cu_2O$ bei einer Temperatur von 1085°C ein Wert von 2,704 angegeben. Dies entspricht einem Sauerstoffpartialgehait von $3,9 \times 10^{-6}$ Atm, was etwa 3,9 ppm ist.

Aus "elektrochemische Gleichgewichtsuntersuchungen am System-Kupfer-Sauerstoff zwischen 1065 und 1300°C", Habilitationsarbeit J. Osterwald, Berlin, 1965 ist für die Temperaturabhängigkeit des Sauerstoffpartialgehaltes folgende Formel bekannt:

$$\log(p_{O2}) = -\,(20970/T) + 10,\ 166.$$

Hierbei sind $p_{O2}$ der Sauerstoffpartialgehalt in ppm und
T die Temperatur in °C.

Hieraus lassen sich in Abhängigkeit von der Temperatur folgende Sauerstoffpartialgehalte bestimmen:

| Temperatur in °C | Partialgehalt in ppm |
|---|---|
| 1065 | 3,1 |
| 1075 | 4,2 |
| 1085 | 5,3 |

In einer weiteren Literaturstelle (Neumann et al Metal Process, 1985, Seite 85) wird der Sauerstoffgehalt des Systems Kupfer-Sauerstoff bei einer eutektischen Temperatur von 1065°C mit $2,69 \times 10^{-6}$ angegeben, was etwa 2,69 ppm entspricht.

Es kann also als gesichert angenommen werden, daß der Gleichgewichtssauerstoffgehalt beim Direct-Bonding von Kupfer und Keramik (DCB-Verfahren) im Bereich zwischen 2 und 6 ppm liegt.

Die eingangs genannten bekannten Verfahren haben demnach u. a. den Nachteil, daß durch den wesentlich größeren Sauerstoffgehalt in der Schutzgasatmosphäre, in der der DCB-Prozeß durchgeführt wird, eine Nachoxidation des Kupfers stattfindet.

Der Erfindung liegt die Erkenntnis zugrunde, daß eine Regelung des Sauerstoffgehaltes in einer Schutzgasatmosphäre im Bereich kleiner 10 ppm insbesondere auch bei einer fabrikmäßigen Produktion von Metall-Keramik-Verbundmaterialien oder -Substraten mit der erforderlichen Genauigkeit nicht, allenfalls nur mit einem extrem hohen technischen Aufwand möglich ist. Weiterhin liegt der Erfindung die Erkenntnis zugrunde, daß ein Sauerstoffpartialdruck oder Sauerstoffanteil in der Schutzgasatmosphäre des DCB-Prozesses kleiner als der Gleichgewichtsdruck des Systems Metall-(Kupfer)-Sauerstoff zu einer Reduzierung der Haftfestigkeit des Metalls (Kupfers) an der Keramik führt, während es bei einem zu hohen Sauerstoffpartialdruck bzw. Sauerstoffgehalt in der Schutzgasatmosphäre zu einer starken Nachoxidation kommt, die im Extremfall ein Aufschmelzen des gesamten Metalls, beispielsweise der gesamten Metall- oder Kupferfolie zur Folge hat.

Aufgabe der Erfindung ist es, ein Verfahren aufzuzeigen, mit dem die Nachteile bekannter Verfahren vermieden werden und mit dem eine vereinfachte Herstellung von Metall-Keramik-Verbundmaterialien, insbesondere Metall-Keramik-Substraten und speziell auch solcher für elektrische oder elektronische Schaltkreise mit höchster Qualität möglich ist.

Zur Lösung dieser Aufgabe ist ein Verfahren entsprechend dem Patentanspruch 1 ausgebildet. Weiterbildungen des Verfahrens sind Gegenstand der Unteransprüche.

Unter "innerer Schutzgasatmosphäre" ist im Sinne der Erfindung die Schutzgasatmosphäre innerhalb des gekapselten Innenraums bzw. Reaktionsraumes einer Kapsel zu verstehen. Unter "äußerer Schutzgasatmosphäre" ist die Schutzgasatmosphäre zu verstehen, die die jeweilige Kapsel während des Direct-Bonding umgibt, d. h. die Schutzgasatmosphäre in einem Ofen.

Bei dem erfindungsgemäßen Verfahren, welches sich insbesondere zur Herstellung von Metall-Keramik-Substraten und dabei speziell zur Herstellung von Kupfer-Keramik-Substraten für die Verwendung als Leiterplatten für elektrische Schaltungen und Schaltkreisen eignet, wird wenigstens ein Keramiksubstrat und eine Metallfolie in dem in der Kapsel gebildeten gekapselten Raum oder Reaktionsraum derart angeordnet, daß die Metallfolie mit einer oxidierten Oberflächenseite flächig gegen eine Oberflächenseite des plattenförmigen Keramiksubstrats anliegt. Zum Herstellen der Verbindung durch Direct-Bonding werden das Keramiksubstrat und die Metallfolie in dem von dem Innenraum der Kapsel gebildeten Reaktionsraum in einer dortigen Schutzgasatmosphäre ("innere Schutzgasatmosphäre") auf eine Temperatur erhitzt, die unter der Schmelztemperatur des Metalls liegt, aber wenigstens gleich der Schmelztemperatur des eutektischen Metalloxids (z. B. $Cu_2O$) ist. In einem anschließenden Verfahrensschritt erfolgt dann das Abkühlen der Kapsel und der in den Reaktionsraum aufgenommenen Komponenten, und zwar wiederum unter Schutzgas.

Die verwendete Kapsel ist beispielsweise nicht vollständig nach außen hin verschlossen ist, sondern besitzt wenigstens eine Öffnung, durch die ein Gasaustausch zwischen der inneren und äußeren Schutzgasatmosphäre stattfinden kann. Dieser Gasaustauch dient u.a. dazu, um am Beginn des Verfahrens die in dem gekapselten Reaktionsraum vorhandene Luft durch das Schutzgas zu verdrängen. Die mit der Kapsel erzielte Kapselung des Reaktionsraumes beträgt allerdings wenigstens 60%. Unter "Kapselung" ist dabei im Sinne der Erfindung der Prozentsatz des geschlossenen Flächenanteils der den gekapselten Innenraum umgebenden Gesamtfläche (Gesamtfläche abzüglich der Fläche der Öffnungen) bezogen auf diese Gesamtfläche zu verstehen. Eine Kapselung von 95% bedeutet also, daß 95% der den Kapselraum umgebenden Fläche verschlossen und nur 5% dieser Gesamtfläche von einer oder mehreren Öffnungen gebildet sind.

Das erfindungsgemäße Verfahren zeichnet sich also aus durch eine zumindest weitestgehende Trennung der Schutzgasatmosphäre in einem Ofenraum ("äußere Schutzgasatmosphäre"), die die wenigstens eine Kapsel umgibt, von der Schutzgasatmosphäre im Innenraum bzw. Reaktionsraum der Kapsel ("innere Schutzgasatmosphäre"), in dem (Reaktionsraum) das Direct-Bonding erfolgt und in dem die Verbindungskomponenten aus Metall und Keramik zumindest mit dem Bereich aufgenommen sind, an dem das Verbinden erfolgen soll.

Bevorzugt ist der Querschnitt der wenigstens einen Öffnung oder aber der Gesamtquerschnitt mehrerer Öffnungen so gewählt, daß dieser Querschnitt bzw. Gesamtquerschnitt weniger als 40% der gesamten, den Reaktionsraum begrenzenden Innenfläche der Kapsel ausmachen, die durch die Kapsel erzielte Kapselung also größer als 60°/° ist.

In überraschender Weise erfolgt bei der Erfindung das Verdrängen der im Kapselinnenraum vorhandenen Luft durch die Schutzgasatmosphäre, wobei gleichzeitig auch erreicht wird, daß der Sauerstoffgehalt in der äußeren Schutzgasatmosphäre keinen oder im wesentlichen keinen Einfluß auf die Qualität des hergestellten Metall-Keramik-Verbundes bzw. des hergestellten Metall-Keramik-Substrates hat, und zwar selbst dann, wenn die äußere Schutzgasatmosphäre einen Sauerstoffgehalt aufweist, der weit unter oder aber weit über dem Gleichgewichtssauerstoffgehalt liegt. Nach einer der Erfindung zugrundeliegenden Erkenntnis ist diese weitestgehende Unabhängigkeit der mit dem erfindungsgemäßen Verfahren erzielten Ergebnis von dem Sauerstoffgehalt der äußeren Schutzgasatmosphäre darauf zurückzuführen, daß bei der relativ hohen Prozeßtemperatur (960 - 1072°C), bei der das Direct-Bonding erfolgt, die Diffusion von Sauerstoff aus der äußeren, die jeweilige Kapsel umgebenden Schutzgasatmosphäre in die innere Schutzgasatmosphäre im Inneren der Kapsel bzw. im Reaktionsraum sehr gering ist. Dieser Effekt kann durch eine gezielte Stromführung der äußeren Schutzgasatmosphäre noch verstärkt werden, und zwar dadurch, daß am Anfang zum Spülen die Strömung auf die Öffnungen der jeweiligen Kapsel gerichtet ist. Bei dem eigentlichen Bonden bei Prozeßtemperatur ist die Strömung dann auf die geschlossene Fläche der Kapsel gerichtet.

Bei einer bevorzugten Ausführungsform des erfindungsgemäßen Verfahrens wird aber der Sauerstoffgehalt in der die Kapsel umgebenden Schutzgasatmosphäre geregelt, zumindest aber durch eine Regelung begrenzt, wobei aber keine allzu große Genauigkeit für die Regelung oder Einstellung erforderlich ist. Hierdurch werden grobe Schwankungen des Sauerstoffgehalts kompensiert, die (Schwankungen) entweder durch den Eintrag von Sauerstoff an den Ofenöffnungen oder durch einen Verbrauch an Sauerstoff in Folge von Oxidation an metallischen Ofenkomponenten herrühren.

Das erfindungsgemäße Verfahren nutzt u.a. die Tatsache, daß bei Gasen die Diffusionsgeschwindigkeit mit steigender Temperatur abnimmt. Dies bedeutet, daß am Beginn des Verfahrens der Innenraum der Kapsel bei der noch herrschenden niedrigen Temperatur durch die noch hohe Diffusionsrate des Schutzgases der äußeren Schutzgasatmosphäre mit diesem Schutzgas gespült wird, d.h. sich eine innere Schutzgasatmosphäre in der Kapsel einstellt, die der äußeren Schutzgasatmosphäre entspricht. Dieses Angleichen der inneren Schutzgasatmosphäre an die äußere Schutzgasatmosphäre kann noch durch eine gezielte Spülung des Innenraumes der Kapsel verstärkt bzw. beschleunigt werden.

Mit zunehmenden Aufheizen der Kapsel, der in dem Innenraum (Reaktionsraum) der Kapsel untergebrachten Verbindungskomponenten sowie der inneren und äußeren Schutzgasatmosphäre auf die Prozeßtemperatur nimmt die Diffusionsrate ab, so daß trotz Öffnungen in der Kapsel tatsächlich eine Trennung oder nahezu eine Trennung der inneren Schutzgasatmosphäre von der äußeren Schutzgasatmosphäre eintritt. Hierdurch stellt sich in der Kapsel bzw. im dortigen Reaktionsraum durch Dissoziation der Oxydschicht der Metallfolie oder durch Reaktion des Sauerstoffs des Schutzgases mit der Metallfolie ein Gleichgewicht für den Sauerstoffgehalt im Reaktionsraum ein, der (Sauerstoffgehalt) eine optimale Verbindung der Verbindungskomponenten, d.h. der wenigstens der einen Metallfolie mit der wenigstens einen Keramikschicht gewährleistet. Die Kapselung beträgt hierfür bevorzugt 60 - 95 %.

Die Einstellung des Sauerstoffgehalts in der äußeren Schutzgasatmosphäre erfolgt bevorzugt in Abhängigkeit von der Kapselung. In Abhängigkeit von der Kapselung wird der Sauerstoffanteil in der äußeren Schutzgasatmosphäre beispielsweise wie folgt eingestellt:

- Kapselung von 60 bis 80% bei einem Sauerstoffgehalt in der äußeren Schutzgasatmosphäre zwischen 2 - 20 ppm in der äußeren Schutzgasatmosphäre,
- Kapselung 80 - 95% bei einem Sauerstoffgehalt in der äußeren Schutzgasatmosphäre zwischen 50 und 200 ppm oder 1 - 20 ppm
- Kapselung über 95% bei einem Sauerstoffgehalt in der äußeren Schutzgasatmosphäre größer 200 ppm oder kleiner 20 ppm

In der nachstehenden Tabelle sind die Ergebnisse von Versuchen wiedergegeben, die mit dem erfindungsgemäßen Verfahren beim Verbinden einer plattenförmigen Keramik (Aluminium-Oxid-Keramik) mit einer von einer Kupferfolie gebildeten Kupferschicht erzielt wurden, und zwar bei unterschiedlichem Sauerstoffgehalt der äußeren Schutzgasatmosphäre und bei unterschiedlicher Kapselung, jeweils bei einer Prozeßtemperatur von 1068°C. Untersucht wurden die Festigkeit der Verbindung zwischen der Keramik und der Kupferschicht bzw. Kupferfolie (Abreißfestigkeit in N/cm) sowie auch die Oberflächenqualität der frei liegenden Kupferflächen (Kupferoberflächenaussehen).

| O$_2$ ppm | Kapselung % | Abreißfestigkeit N/cm | Kupferoberflächen- aussehen |
|---|---|---|---|
| < 2 | 95 | > 60 | blank |
| < 2 | 80 | 50 | blank |
| < 2 | 60 | 40 | blank |
| < 2 | 50 | 30 | blank |
| 10 | 95 | > 60 | blank |
| 10 | 60 | > 60 | blank |
| 10 | 50 | > 60 | leicht oxidiert |

(fortgesetzt)

| O₂ ppm | Kapselung % | Abreißfestigkeit N/cm | Kupferoberflächen- aussehen |
|---|---|---|---|
| 20 | 95 | > 60 | blank |
| 20 | 80 | > 60 | blank |
| 20 | 50 | > 60 | leicht oxidiert |
| 50 | 95 | > 60 | blank |
| 50 | 80 | > 60 | blank |
| 50 | 60 | > 60 | blank |
| 50 | 50 | > 60 | oxidiert |
| 100 | 95 | > 60 | blank |
| 100 | 80 | > 60 | blank |
| 100 | 60 | > 60 | leicht oxidiert |
| 100 | 40 | > 60 | stark oxidiert |
| 200 | 95 | > 60 | blank |
| 200 | 80 | > 60 | oxidiert |

In der vorgenannten Tabelle sind also der Einfluß des Sauerstoffgehalts in der äußeren Atmosphäre und der Kapselung auf die Abreißfestigkeit und die Beschaffenheit der Kupferoberflächen wiedergegeben.

Vorstehend wurde davon ausgegangen, daß die Kapselung des Reaktionsraumes nicht hundertprozentig ist, sondern der Reaktionsraum über eine Öffnung mit der äußeren Schutzgasatmosphäre in Verbindung steht, um so das Einbringen der Verbindungskomponenten in den gekapselten Reaktionsraum in normaler Atmosphäre und am Beginn des eigentlichen Verfahrens ein Verdrängen der normalen Atmosphäre, insbesondere auch der Luft aus dem Reaktionsraum durch das Schutzgas zu ermöglichen.

Zur Schaffung der erforderlichen Schutzgasatmosphäre im Reaktionsraum der Kapsel wird die jeweilige Kapsel über die vorhandenen Öffnungen mit dem Schutzgas der äußeren Schutzgasatmosphäre gespült, d. h. die in der Kapsel vorhandene Luft wird durch das Schutzgas verdrängt. Beträgt die Kapselung 100%, so ist es erforderlich, den Reaktionsraum vor dem Direct-Bonden anderweitig mit Schutzgas zu spülen, d. h. im Reaktionsraum die vorhandene Luft durch das Schutzgas zu ersetzen.

Das wenigstens eine Keramiksubstrat sowie die wenigstens eine Metallfolie können getrennt nacheinander in die jeweilige Kapsel eingelegt werden, oder aber als außerhalb der Kapsel vorbereiteter Stapel.

Die Metallfolie wird beispielsweise vor dem Einbringen in die Kapsel in einem vorausgegangenen Verfahrensschritt oxidiert, beispielsweise durch Behandlung mit einem geeigneten reaktiven Gas, z. B. Sauerstoff. Bei dem erfindungsgemäßen Verfahren kann aber auch eine bereits voroxidierte Metallfolie verwendet werden. Sauerstoff als reaktives Gas eignet sich insbesondere bei Metallfolien aus Kupfer.

Das Erhitzen der jeweiligen Kapsel und der in dieser Kapsel untergebrachten Komponenten auf die Direct-Bonding-Temperatur erfolgt in einem Ofen, bevorzugt in einem Durchlauf oder Tunnelofen, wobei der Ofenraum die äußere Schutzgasatmosphäre mit einem eingestellten bzw. geregelten Sauerstoffgehalt enthält. Die Einstellung des Sauerstoffgehaltes in der äußeren Schutzgasatmosphäre erfolgt durch Zudosieren von Sauerstoff in das Schutzgas.

Grundsätzlich besteht aber auch die Möglichkeit einer hundertprozentigen Kapselung des Reaktionsraumes, wobei dann in diesen Reaktionsraum eine Schutzgasatmosphäre eingebracht werden muß, die einen gewissen Anteil an Sauerstoff enthält.

Es ist aber auch möglich, mit einem sauerstofffreien Schutzgas zu arbeiten, und zwar dann, wenn ein dem freien Volumen im Inneren der Kapsel entsprechend hoher OxidGehalt auf der Metallfolie vorgesehen wird. Durch Dissoziation des Oxids stellt sich dann der notwendige Gleichgewichtssauerstoffgehalt ein.

Bevorzugt enthält der gekapselte Raum eine Puffersubstanz, zumindest bei einer 100%-igen Kapselung, mit der (Puffersubstanz) der Sauerstoffpartialdruck in der inneren Schutzgasatmosphäre, d.h. im gekapselten Reaktionsraum bei der Reaktions- oder Bonding-Temperatur auf einen Wert eingestellt und/oder gehalten wird, der eine optimale DCB-Verbindung zwischen dem Metall (Kupfer) und der Keramik sicherstellt, und zwar bei gleichzeitiger Verhinderung einer zumindest störenden Nachoxidation. Dieser durch die Puffersubstanz eingestellte Sauerstoffpartialdruck liegt dann vorzugsweise zwischen 3 - 10 ppm. Die Puffersubstanz enthält beispielsweise CuO in Form von Pulver, gegebenenfalls gemischt mit Kupferpulver.

Die Erfindung wird im folgenden anhand der Figuren an Ausführungsbeispielen näher erläutert. Es zeigen:

Fig. 1 - 5   jeweils in vereinfachter Darstellung verschiedene Möglichkeiten der Ausbildung der Kapsel;
Fig. 6   in vereinfachter Teildarstellung und in Draufsicht einen Durchlaufofen zur Durchführung des erfindungsgemäßen Verfahrens.

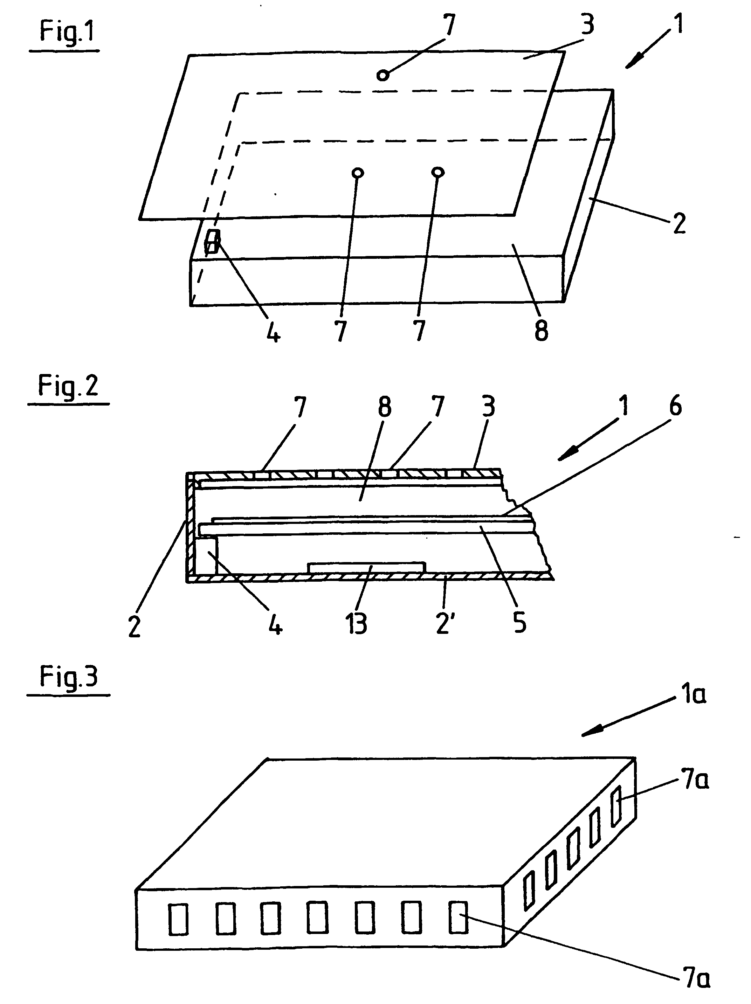

Die in der Figur 1 dargestellte und allgemein mit 1 bezeichnete Kapsel ist als flache, rechteckförmige oder quadratische Schale oder Schachtel ausgeführt, und zwar mit einem an seiner Oberseite offenen Unterteil 2 und mit einem Deckel 3, mit dem das Unterteil 2 an seiner Oberseite verschlossen werden kann. Im Unterteil 2 sind Anlageelemente 4 gebildet, auf die entsprechend der Schnittdarstellung der Figur 2 für die Durchführung des Verfahrens eine Keramikplatte 5 aufgelegt ist, auf deren Oberseite eine an ihren Oberflächenseiten oxidierte und von einer Kupferfolie gebildete Kupferschicht 6 aufliegt, so daß die Schichtfolge bestehend aus der Keramikschicht 5 und der Kupferschicht 6 bei geschlossenem Deckel 3 sowohl von diesem Deckel als auch von der Unterseite bzw. Bodenfläche 2' des Unterteils beabstandet sind. Im Deckel 3 sind Öffnungen 7 vorgesehen, über die der gekapselte Innenraum bzw. Reaktionsraum 8 mit der Umgebung in Verbindung steht. Das Verbinden der Kupferschicht 6 mit der Keramikschicht 5 erfolgt in einem Durchlaufofen. Die geschlossene Kapsel 1 mit den in dieser Kapsel angeordneten Verbindungskomponenten (Keramikschicht 5/Kupferschicht 6) wird an einem Einlauf in den Ofen eingebracht. In einer ersten Ofenzone erfolgt dann über die Öffnungen 7 der Austausch der Luft bzw. des Sauerstoffes im Reaktionsraum 8 durch die Schutzgasatmosphäre, die dann beispielsweise bei einer Kapselung von 95% einen Sauerstoffanteil zwischen 100 und 200 ppm enthält. In einer weiteren Ofenzone erfolgt das Erhitzen der Kapsel 1 und der in dieser Kapsel angeordneten Verbindungskomponenten auf die für die Herstellung der DCB-Verbindung notwendige Prozeßtemperatur von beispielsweise 1068°C. In einer weiteren anschließenden Ofenzone erfolgt dann das Abkühlen der Kapsel 1 und der in dieser Kapsel enthaltenen Verbindungskomponenten, die dann zu dem Metall-KeramikSubstrat mit einander verbunden sind.

Die Figur 3 zeigt als weitere mögliche Ausführungsform eine Kapsel 1a, die sich von der Kapsel 1 im wesentlichen nur dadurch unterscheidet, daß anstelle der Öffnungen 7 im Deckel 3 oder aber zusätzlich zu diesen Öffnungen weitere Öffnungen 7a an der Umfangsfläche der Kapsel 1a vorgesehen sind. Hierdurch ist es insbesondere auch möglich, mehrere Kapseln 1a übereinander gestapelt im Ofen zu verwenden.

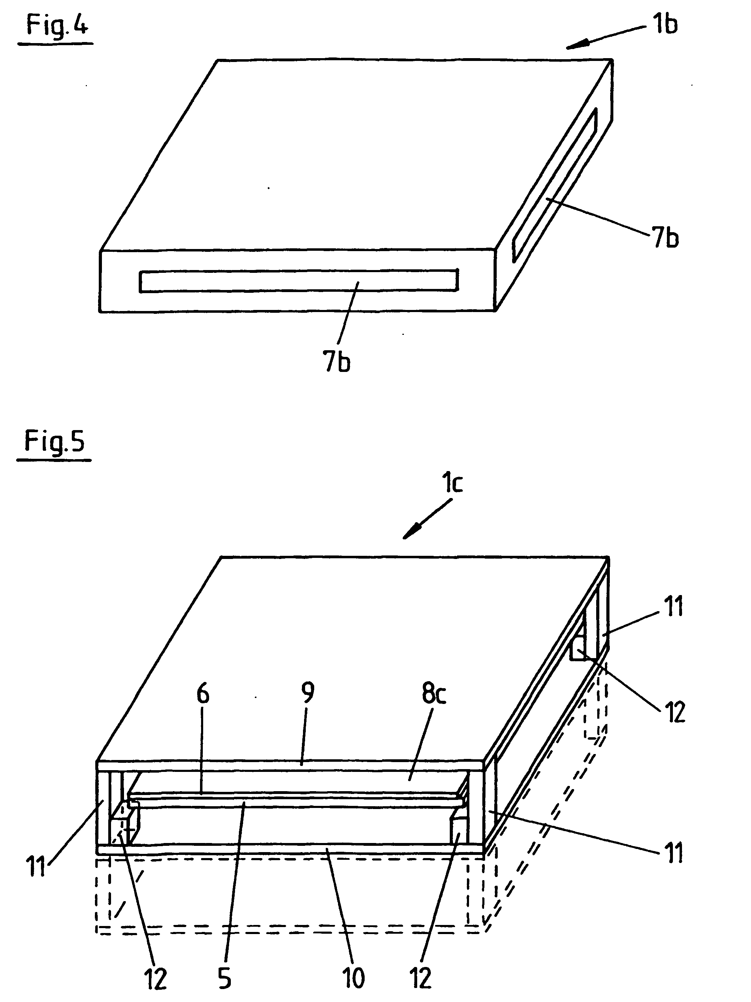

Die Figur 4 zeigt als weitere Möglichkeit einer Kapsel 1b, die sich von der Kapsel 1a im wesentlichen dadurch unterscheidet, daß anstelle einer Vielzahl von Öffnungen 1a jeweils nur eine Öffnung 7b an jeder Umfangsseite des flachen, rechteckförmigen oder quadratischen Unterteils 2b vorgesehen ist.

Die Figur 5 zeigt als weitere mögliche Ausführungsform eine Kapsel 1c, die im wesentlichen aus einer oberen Platte 9 und einer unteren Platte 10 besteht, die parallel zueinander angeordnet und über Abstandhalter oder Pfosten 11 miteinander verbunden sind. Letztere sind in den Ecken der rechteckförmigen oder quadratischen Platten 9 und 10 vorgesehen. In den zwischen den Platten 9 und 10 gebildeten Raum 8c, der von seiner Funktion her dem Raum 8 der Kapsel 1 entspricht und bei der dargestellten Ausführungsform am gesamten Umfang der Kapsel 1c offen ist, können die Verbindungskomponenten einzeln nach einander oder bereits als Stapel durch seitliches Einschieben eingebracht werden, und zwar derart, daß sich die von den Verbindungskomponenten gebildete Schichtfolge mit der Keramikschicht 6 auf Auflageelementen 12 abstützt, die an der unteren Platte 10 vorgesehen sind.

Grundsätzlich besteht die Möglichkeit, die Kapsel 1c auch so auszubilden, daß der Raum 8c an wenigstens einer Umfangsseite durch eine Wandung verschlossen ist, und zwar im Extremfall an drei Umfangsseiten, so daß nur eine Umfangsseite offen ist, über die das Eindringen der Verbindungskomponenten sowie das Ausbringen des hergestellten Metall- (Kupfer)-Keramik-Substrats möglich ist.

Die Kapseln 1, 1a, 1b, 1c bestehen aus einem hochtemperaturfesten und oxidationsbeständigen Material, beispielsweise aus einem entsprechenden Metall oder aber aus einer oder mehreren Keramikmaterialien, wie bei-spielsweise $Al_2O_3$, $Si_3N_4$, SiC oder Forsterit bzw. Mullit. Auch andere geeignete Materialien für die Kapseln sind denkbar.

Die Kapseln 1, 1a, 1b, 1c können beispielsweise bei Verwendung eines Durchlaufofens in mehreren Reihen nebeneinander verwendet werden und/oder gestapelt, wobei für diese letztgenannte Anwendung insbesondere die an ihrem Umfang offenen Kapseln 1a, 1b und 1c besonders geeignet sind, wie dies in der Figur 5 mit unterbrochenen Linien angedeutet ist.

Die vorbeschriebenen Kapseln 1 - 1c weisen jeweils Öffnungen auf. Grundsätzlich besteht, wie bereits ausgeführt, auch die Möglichkeit, den in der Kapsel gebildeten Reaktionsraum vollständig oder nahezu vollständig nach außen hin zu verschließen, beispielsweise dadurch, daß bei der Kapsel 1 ein Deckel 3 ohne die Öffnungen 7 verwendet wird. Mit 13 ist in der Figur 2 noch ein Puffermaterial zur Einstellung des Sauerstoffgehaltes bzw. -anteils im Raum 8 angedeutet, und zwar insbesondere dann, wenn dieser Reaktionsraum vollständig oder nahezu vollständig nach außen verschlossen ist. Auch bei verschlossenem Reaktionsraum wird das Verfahren in einer äußeren Schutzgasatmosphäre durchgeführt, da ein absolut dichter Abschluß nicht oder nur mit einem nicht vertretbaren hohen Aufwand möglich wäre.

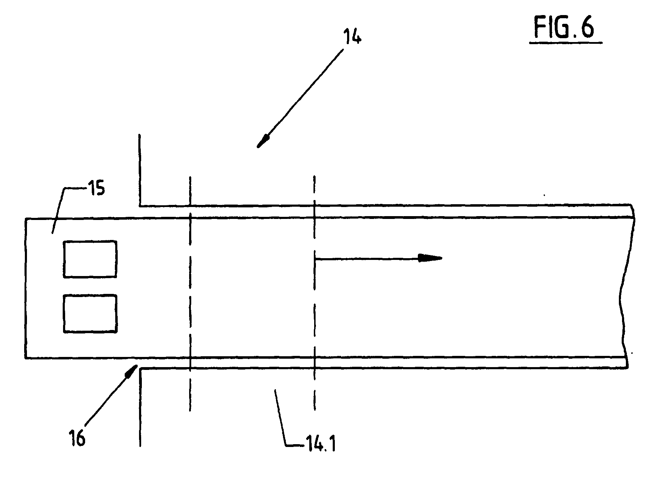

In der Figur 6 ist mit 14 allgemein ein Tunnelofen mit einem Transportband 15 bezeichnet, auf dem die Kapseln 1, 1a, 1b, 1c mit den in diesen Kapseln untergebrachten Verbindungskomponenten (Keramikschicht 5 und Kupferschicht 6) durch den Tunnelofen 14 bzw. durch verschiedene Zonen dieses Ofens bewegt werden, und zwar u.a. auch durch eine Vorspülzone 14.1, an der der Innen- oder Reaktionsraum 8 der Kapseln durch ihre Öffnungen mit einem gerichteten Schutzgasstrom gespült werden. Die Spülzonen 14.1 befinden sich dabei in der Nähe des Einlasses 16 des Tunnelofens 14, an dem (Einlaß) die Kapseln mit den Verbindungskomponenten auf den Transporteur 15 aufgelegt werden.

An die Zone 14.1 schließen sich dann eine oder mehrere Temperaturzonen an, in denen das Erhitzen auf die Prozeßtemperatur erfolgt, wobei auch die Zone 14.1 bereits Bestandteil einer solchen Temperaturzone sein kann. Anschließend erfolgt in wenigstens einer weiteren Zone ein Abkühlen der Kapseln, bevor diese dann an dem nicht dargestellten Auslaß des Tunnelofens 14 entnommen werden.

Die Erfindung wurde voranstehend an Ausführungsbeispielen beschrieben. Es versteht sich, daß zahlreiche Änderungen sowie Abwandlungen möglich sind, ohne daß dadurch der der Erfindung zugrundeliegende Erfindungsgedanke verlassen wird.

**Bezugszeichenliste**

| 1, 1a, 1b, 1c | Kapsel |
|---|---|
| 2 | Unterteil |
| 2' | Unterteilboden |
| 3 | Deckel |
| 4 | An lageelement |
| 5 | Keramikplatte |
| 6 | Kupferschicht oder Kupferfolie |
| 7, 7a, 7b | Öffnung |
| 8, 8c | Reaktionsraum oder Kapselinnenraum |
| 9 | obere Platte der Kapsel 1c |
| 10 | untere Platte der Kapsel 1c |
| 11 | Pfosten |
| 12 | Auflageelement |
| 13 | Puffermaterial |
| 14 | Tunnelofen |
| 14.1 | Spülzone des Tunnelofens |
| 14.2 | Temperaturzone des Tunnelofens |
| 14, 15 | Transportband |
| 16 | Einlauf |

**Patentansprüche**

**1.** Verfahren zum Herstellen von Metall-Keramik-Verbundmaterialien, insbesondere Metall-Keramik-Substraten, bei dem (Verfahren) als Verbindungskomponenten wenigstens ein vorzugsweises plattenförmiges Keramiksubstrat mit einer oxidierten Metallfolie verbunden wird, und zwar durch Erhitzen unter Schutzgas auf eine Prozeßtemperatur, die unterhalb des Schmelzpunkts des Metalls der Metallfolie liegt, aber wenigstens gleich der Schmelztemperatur des von der Oxidschicht gebildeten Eutektikums ist, **dadurch gekennzeichnet, daß** das wenigstens eine Keramiksubstrat und die mit diesem zu verbindende wenigstens eine Metallfolie während des Verfahrens in einem von einer Kapsel (1, 1a, 1b, 1c) gebildeten Reaktionsraum (8, 8c) mit einer inneren Schutzgasatmosphäre untergebracht sind, die durch die Kapsel (1, 1a, 1b, 1c) von einer diese Kapsel umgebenden äußeren Schutzgasatmosphäre getrennt ist.

**2.** Verfahren nach Anspruch 1, **dadurch gekennzeichnet, daß** der Reaktionsraum gegenüber der äußeren, die Kapsel umgebenden Schutzgasatmosphäre dicht verschlossen ist.

**3.** Verfahren nach Anspruch 1, **dadurch gekennzeichnet, daß** der Reaktionsraum mit der die Kapsel (1, 1a, 1c) umgebenden äußeren Schutzgasatmosphäre über einen Öffnungsquerschitt in Verbindung steht, und daß der Öffnungsquerschnitt so gewählt ist, daß eine Kapselung des Reaktionsraumes, die (Kapselung) als prozentualer Anteil eines geschlossenen Teils einer den Reaktionsraum umschließenden Gesamtfläche bezogen auf diese Gesamtfläche definiert ist, größer als 60% ist.

4. Verfahren nach einem der vorhergehenden Ansprüche, **dadurch gekennzeichnet, daß** die Kapsel wenigstens eine Öffnung (7, 7a, 7b) aufweist.

5. Verfahren nach einem der vorhergehenden Ansprüche, **dadurch gekennzeichnet, daß** der bei dem Verfahren maximal zulässige Sauerstoffanteil in der äußeren Schutzgasatmosphäre mit zunehmender Kapselung zunimmt.

6. Verfahren nach einem der vorhergehenden Ansprüche, **dadurch gekennzeichnet, daß** die äußere Schutzgasatmosphäre bei einer Kapselung zwischen 60 und 80% etwa 50 bis 100 ppm Sauerstoff enthält.

7. Verfahren nach einem der vorhergehenden Ansprüche, **dadurch gekennzeichnet, daß** die äußere Schutzgasatmosphäre bei einer Kapselung zwischen 60 und 80% etwa 2 bis 20 ppm Sauerstoff enthält.

8. Verfahren nach einem der vorhergehenden Ansprüche, **dadurch gekennzeichnet, daß** die äußere Schutzgasatmosphäre bei einer Kapselung von 80 - 95% 50 bis 200 ppm Sauerstoff enthält.

9. Verfahren nach einem der vorhergehenden Ansprüche, **dadurch gekennzeichnet, daß** die äußere Schutzgasatmosphäre bei einer Kapselung von 80 - 95% 1 bis 20 ppm Sauerstoff enthält.

10. Verfahren nach einem der vorhergehenden Ansprüche, **dadurch gekennzeichnet, daß** die äußere Schutzgasatmosphäre bei einer Kapselung größer 95% Sauerstoff in einem Anteil kleiner 20 ppm oder größer 200 ppm enthält.

11. Verfahren nach einem der vorhergehenden Ansprüche, **gekennzeichnet durch** die Verwendung einer Kapsel aus einem hochtemperaturfesten und oxidationsbeständigen Material, beispielsweise Metall.

12. Verfahren nach einem der vorhergehenden Ansprüche, **gekennzeichnet durch** die Verwendung einer Kapsel, die aus wenigstens einem Keramikmaterial, beispielsweise aus $Al_2O_3$, $Si_3N_4$, SiC, Forsterit und/oder Mullit besteht.

13. Verfahren nach einem der vorhergehenden Ansprüche, **gekennzeichnet durch** die Verwendung einer Kapsel in Form eines den Reaktionsraum umschließenden Rahmens.

14. Verfahren nach einem der vorhergehenden Ansprüche, **gekennzeichnet durch** die Verwendung einer Kapsel bestehend aus einer oberen Wandung und einer unteren Wandung sowie aus diese Wandungen im gegenseitigen Abstand haltenden Abstandhaltern (11).

15. Verfahren nach einem der vorhergehenden Ansprüche, **gekennzeichnet durch** die Verwendung einer Kapsel (1c); die an wenigstens einer Umfangsseite zum Einbringen und Entnehmen der Komponenten offen ist.

16. Verfahren nach einem der vorhergehenden Ansprüche, **gekennzeichnet durch** die Verwendung einer schalenartigen Kapsel (1, 1a, 1b) mit einem Deckel (3).

17. Verfahren nach einem der vorhergehenden Ansprüche, **gekennzeichnet durch** die Verwendung einer Kapsel mit wenigstens einer Öffnung (7, 7a, 7b) an einer Umfangsseite und/oder an einem Boden und/oder an einem Deckel.

18. Verfahren nach einem der vorhergehenden Ansprüche, **gekennzeichnet durch** die Verwendung einer Kapsel mit wenigstens einer Anlage (4, 12) für die Verbindungskomponenten.

19. Verfahren nach einem der vorhergehenden Ansprüche, **gekennzeichnet durch** die Verwendung einer Kapsel mit einer im Reaktionsraum untergebrachten Puffersubstanz zur Schaffung eines Sauerstoffgleichgewichtspotenzial im Reaktionsraum während des Direct-Bondens.

20. Verfahren nach Anspruch 17, **gekennzeichnet durch** die Verwendung einer Puffersubstanz (13) auf der Basis von Kupferoxid, vorzugsweise auf der Basis Kupferoxid/Kupfer.

21. Verfahren nach einem der vorhergehenden Ansprüche, **dadurch gekennzeichnet, daß** die Kapselung im Bereich von 99 bis 65% gewählt ist.

**22.** Verfahren nach einem der vorhergehenden Ansprüche, **gekennzeichnet durch** die Verwendung eines Tunnel- oder Durchlaufofens, bei dem die Kapseln (1, 1a, 1b, 1c) auf einem Transporteur angeordnet sind.

**23.** Verfahren nach einem der vorhergehenden Ansprüche, **dadurch gekennzeichnet, daß** mehrere Kapseln (1, 1a, 1b, 1c) gestapelt und/oder in mehreren Reihen nebeneinander auf einem Transporteur des Durchlauf- oder Tunnelofens angeordnet verwendet werden.

**24.** Verfahren nach einem der vorhergehenden Ansprüche, **dadurch gekennzeichnet, daß** im Durchlaufofen vor dem Direct-Bonden bzw. Erhitzen auf die Prozeß- oder Bonding-Temperatur eine Aufheizung der wenigstens einen Kapsel und nach dem Bonden ein Abkühlen der Kapseln erfolgt, und zwar jeweils in der äußeren Schutzgasatmosphäre.

**25.** Verfahren nach einem der vorhergehenden Ansprüche, **dadurch gekennzeichnet, daß** vor dem Erhitzen der jeweiligen Kapsel (1, 1a, 1b, 1c) mit den Verbindungskomponenten auf die Prozeßtemperatur wenigstens einmal ein Spülen des Reaktionsraumes (8, 8c) mit einem Spülgasstrom durch die Öffnungen der Kapsel (1, 1a, 1b, 1c) erfolgt, wobei das Gas des Spülgasstromes vorzugsweise das Gas der äußeren Schutzgasatmosphäre ist.

## Claims

**1.** Method for manufacturing metal/ceramic composite materials, in particular metal/ceramic substrates, in which (method), as the components for joining, at least one preferably plate-shaped ceramic substrate is joined to an oxidised metal foil, namely through heating under inert gas to a process temperature that lies below the melting point of the metal of the metal foil, but is at least equal to the melting temperature of the eutectic composition formed by the oxide layer,
**characterised in that**
the at least one ceramic substrate and the at least one metal foil that is to be joined to it are accommodated during the procedure in a reaction space (8, 8c) which is formed by a capsule (1, 1a, 1b, 1c) and which has an internal inert gas atmosphere that is separated by the capsule (1, 1a, 1b, 1c) from the external inert gas atmosphere that surrounds this capsule.

**2.** Method according to claim 1, **characterised in that** the reaction space is tightly sealed in relation to the external inert gas atmosphere that surrounds the capsule.

**3.** Method according to claim 1, **characterised in that** the reaction space is connected to the external atmosphere that surrounds the capsule (1, 1a, 1b, 1c) via an opening cross-section, and that the opening cross-section is selected such that an encapsulation of the reaction space, which (encapsulation) is defined as a percentage proportion of a closed part of an overall area that encloses the reaction space in relation to this overall area that is greater than 60%.

**4.** Method according to one of the preceding claims, **characterised in that** the capsule has at least one opening (7, 7a, 7b).

**5.** Method according to one of the preceding claims, **characterised in that** the maximum permitted oxygen content for the method increases in the external inert gas atmosphere with increasing encapsulation.

**6.** Method according to one of the preceding claims, **characterised in that** in the case of encapsulation between 60 and 80%, the external inert gas atmosphere contains around 50 to 100 ppm oxygen.

**7.** Method according to one of the preceding claims, **characterised in that** in the case of encapsulation between 60 and 80%, the external inert gas atmosphere contains around 2 to 20 ppm oxygen.

**8.** Method according to one of the preceding claims, **characterised in that** in the case of encapsulation of 80-95 %, the external inert gas atmosphere contains 50 to 200 ppm oxygen.

**9.** Method according to one of the preceding claims, **characterised in that** in the case of encapsulation of 80-95 %, the external inert gas atmosphere contains 1 to 20 ppm oxygen.

**10.** Method according to one of the preceding claims, **characterised in that** in the case of encapsulation greater than 95%, the external inert gas atmosphere contains a proportion of less than 20 ppm or greater than 200 ppm.

**11.** Method according to one of the preceding claims, **characterised by** the use of a capsule of material that is proof against high temperatures and is resistant to oxidation, for example metal.

**12.** Method according to one of the preceding claims, **characterised by** the use of a capsule that comprises at least one ceramic material, for example $Al_2O_3$, $Si_3N_4$, SiC, forsterite and/or mullite.

**13.** Method according to one of the preceding claims, **characterised by** the use of a capsule in the form of a frame that encloses the reaction space.

**14.** Method according to one of the preceding claims, **characterised by** the use of a capsule comprising an upper wall and a lower wall, as well as spacers (11) that hold these walls at a distance from one another.

**15.** Method according to one of the preceding claims, **characterised by** the use of a capsule (1c) that is open on at least one peripheral side, for inserting and removing the components.

**16.** Method according to one of the preceding claims, **characterised by** the use of a shell-like capsule (1, 1a, 1b) with a lid (3).

**17.** Method according to one of the preceding claims, **characterised by** the use of a capsule with at least one opening (7, 7a, 7b) on a peripheral side and/or on a floor and/or on a lid.

**18.** Method according to one of the preceding claims, **characterised by** the use of a capsule with at least one resting point (4, 12) for the components that are to be joined.

**19.** Method according to one of the preceding claims, **characterised by** the use of a capsule with a buffer substance accommodated in the reaction space, to create an oxygen equilibrium potential in the reaction space during direct bonding.

**20.** Method according to claim 17, **characterised by** the use of a buffer substance (13) based on copper oxide, preferably based on copper oxide/copper.

**21.** Method according to one of the preceding claims, **characterised in that** the encapsulation is chosen to be in the range of 99 to 65%.

**22.** Method according to one of the preceding claims, **characterised by** the use of a tunnel furnace or flow-through furnace, in which the capsules (1, 1a, 1b, 1c) are arranged on a transporter.

**23.** Method according to one of the preceding claims, **characterised in that** several capsules (1, 1a, 1b, 1c) are used stacked and/or arranged in several rows next to one another on a transporter of the through-flow furnace or tunnel furnace.

**24.** Method according to one of the preceding claims, **characterised in that** in the through-flow furnace, before direct bonding or heating up to the process temperature or bonding temperature, the at least one capsule is heated up and, after bonding, a cooling of the capsules takes place, and in fact respectively in the external inert has atmosphere.

**25.** Method according to one of the preceding claims, **characterised in that** before the respective capsule (1, 1a, 1b, 1c) with the components that are to be joined is heated up to the process temperature, the reaction space (8, 8c) is flushed at least once with a flow of circulation gas through the openings of the capsule (1, 1a, 1b, 1c), wherein the gas of the circulation gas flow is preferably the gas of the external inert gas atmosphere.

**Revendications**

**1.** Procédé de fabrication de matériaux composites métallo-céramiques et en particulier de supports métallo-céramiques, dans lequel (procédé) les composants de liaison que l'on relie sont au moins un support céramique de préférence en forme de plaque et un film métallique oxydé, la température de traitement à laquelle la liaison est effectuée par chauffage sous gaz de protection étant inférieure au point de fusion du métal du film métallique mais au moins égale à la température de fusion du système eutectique formé par la couche d'oxyde, **caractérisé en ce qu'**au cours du traitement, au moins un support céramique et l'au moins un film métallique qui doit y être relié sont introduits dans un espace de réaction (8, 8c) qui est formé par une capsule (1, 1a, 1b, 1c) et qui présente une atmosphère intérieure de gaz de protection que la capsule (1, 1a, 1b, 1c) sépare d'une atmosphère extérieure de gaz de protection qui entoure cette capsule.

2. Procédé selon la revendication 1, **caractérisé en ce que** l'espace de réaction est hermétiquement isolé de l'atmosphère extérieure de gaz de protection qui entoure la capsule.

3. Procédé selon la revendication 1, **caractérisé en ce qu'**une section transversale d'ouverture relie l'espace de réaction à l'atmosphère extérieure de gaz de protection qui entoure la capsule (1, 1a, 1b, 1c) et **en ce que** cette section transversale d'ouverture est sélectionnée de telle manière que l'encapsulation de l'espace de réaction, qui (le taux d'encapsulation) est défini comme la proportion, en pourcentage de la surface totale, de la partie fermée de la surface totale qui contient l'espace de réaction dépasse 60 %.

4. Procédé selon l'une des revendications précédentes, **caractérisé en ce que** la capsule présente au moins une ouverture (7, 7a, 7b).

5. Procédé selon l'une des revendications précédentes, **caractérisé en ce que** la teneur en oxygène maximale qui peut être tolérée dans l'atmosphère extérieure de gaz de protection lors du processus augmente à mesure que l'encapsulation augmente.

6. Procédé selon l'une des revendications précédentes, **caractérisé en ce que** l'atmosphère extérieure de gaz de protection contient sensiblement entre 50 et 100 ppm d'oxygène lorsque l'encapsulation est comprise entre 60 et 80 %.

7. Procédé selon l'une des revendications précédentes, **caractérisé en ce que** l'atmosphère extérieure de gaz de protection contient entre 2 et 20 ppm d'oxygène lorsque l'encapsulation est comprise entre 60 et 80 %.

8. Procédé selon l'une des revendications précédentes, **caractérisé en ce que** l'atmosphère extérieure de gaz de protection contient entre 50 et 200 ppm d'oxygène lorsque l'encapsulation est comprise entre 80 et 95 %.

9. Procédé selon l'une des revendications précédentes, **caractérisé en ce que** l'atmosphère extérieure de gaz de protection contient sensiblement entre 1 et 20 ppm d'oxygène lorsque l'encapsulation est comprise entre 80 et 95 %.

10. Procédé selon l'une des revendications précédentes, **caractérisé en ce que** l'atmosphère extérieure de gaz de protection contient une teneur en oxygène inférieure à 20 ppm ou supérieure à 200 ppm lorsque l'encapsulation est supérieure à 95 %.

11. Procédé selon l'une des revendications précédentes, **caractérisé par** l'utilisation d'une capsule en un matériau qui résiste aux hautes températures et à l'oxydation, par exemple un métal.

12. Procédé selon l'une des revendications précédentes, **caractérisé par** l'utilisation d'une capsule constituée d'au moins un matériau céramique, par exemple l'$Al_2O_3$, le $Si_3N_4$, le SiC, la forstérite et/ou la mullite.

13. Procédé selon l'une des revendications précédentes, **caractérisé par** l'utilisation d'une capsule sous la forme d'un cadre qui entoure l'espace de réaction.

14. Procédé selon l'une des revendications précédentes, **caractérisé par** l'utilisation d'une capsule constituée d'une paroi supérieure, d'une paroi inférieure et d'écarteurs (11) qui maintiennent ces parois à distance l'une de l'autre.

15. Procédé selon l'une des revendications précédentes, **caractérisé par** l'utilisation d'une capsule (1c) dont au moins un côté de pourtour est ouvert en vue de l'introduction et de l'enlèvement des composants.

**16.** Procédé selon l'une des revendications précédentes, **caractérisé par** l'utilisation d'une capsule du type en coquille (1, 1a, 1b), qui présente un couvercle (3).

**17.** Procédé selon l'une des revendications précédentes, **caractérisé par** l'utilisation d'une capsule dont un côté de pourtour, un fond et/ou un couvercle présentent au moins une ouverture (7, 7a, 7b).

**18.** Procédé selon l'une des revendications précédentes, **caractérisé par** l'utilisation d'une capsule qui présente au moins un support (4, 12) pour les composants de liaison.

**19.** Procédé selon l'une des revendications précédentes, **caractérisé par** l'utilisation d'une capsule qui présente au moins une substance tampon qui est introduite dans l'espace de réaction et qui sert à créer un potentiel d'équilibrage de l'oxygène dans l'espace de réaction lors de la liaison directe.

**20.** Procédé selon la revendication 17, **caractérisé par** l'utilisation d'une surface tampon (13) à base d'oxyde de cuivre et de préférence à base de cuivre et d'oxyde de cuivre.

**21.** Procédé selon l'une des revendications précédentes, **caractérisé en ce que** l'encapsulation est sélectionné dans la plage comprise entre 65 et 99 %.

**22.** Procédé selon l'une des revendications précédentes, **caractérisé par** l'utilisation d'un four tunnel ou d'un four continu dans lesquels les capsules (1, 1a, 1b, 1c) sont agencées sur un transporteur.

**23.** Procédé selon l'une des revendications précédentes, **caractérisé en ce qu'**on utilise plusieurs capsules (1, 1a, 1b, 1c) empilées et/ou agencées en plusieurs rangées les unes à côté des autres sur un transporteur du four continu ou du four tunnel.

**24.** Procédé selon l'une des revendications précédentes, **caractérisé en ce qu'**avant la liaison directe et avant le chauffage à la température de traitement ou à la température de liaison, on chauffe l'au moins une capsule dans le tour continu et, après la liaison, on refroidit la ou les capsules, chacune des deux opérations étant exécutée dans l'atmosphère extérieure de gaz de protection.

**25.** Procédé selon l'une des revendications précédentes, **caractérisé en ce qu'**avant de chauffer à la température de traitement chaque capsule (1, 1a, 1b, 1c) qui présente les composants de liaison, on nettoie au moins une fois l'espace de réaction (8, 8c) au moyen d'un écoulement de gaz de nettoyage à travers les ouvertures de la capsule (1, 1a, 1b, 1c), le gaz de l'écoulement de gaz de nettoyage étant de préférence le gaz de l'atmosphère extérieure de gaz de protection.

**Fig.1**

**Fig.2**

**Fig.3**

Fig.4

1b

7b

7b

Fig.5

1c

11

12

6    9    8c

11

11

12   5    10   12

FIG.6